# EUROPEAN PATENT APPLICATION

(11) **EP 3 836 203 A1**
(43) Date of publication of application: **16.06.2021**
(21) Application number: 20197831.9
(22) Date of filing: 23.09.2020
(51) Int. Cl.: H01L 21/8234, H01L 27/088, H01L 29/06, H01L 29/66, H01L 29/775, H01L 29/78, H01L 27/092, H01L 21/8238

(54) **LONG CHANNEL NANOWIRE TRANSISTORS FOR SOC APPLICATIONS**

(30) Priority: 13.12.2019 US 201916713600
(71) Applicant: INTEL Corporation, Santa Clara, CA 95054 (US)
(72) Inventor: RAMASWAMY, Rahul, Portland, OR 97229 (US); HAFEZ, Walid M., Portland, OR 97229 (US); NIDHI, Nidhi, Hillsboro, OR 97124 (US); CHANG, Ting, Portland, 97229 (US); CHANG, Hsu-Yu, Hillsboro, OR 97124 (US); TRIVEDI, Tanuj, Hillsboro, OR 97124 (US); KIM, Jeong Dong, Scappoose, OR 97056 (US); FALLAHAZAD, Babak, Portland, OR 97229 (US)
(74) Representative: 2SPL Patentanwälte PartG mbB

(57) **Abstract**

Embodiments disclosed herein include nanoribbon and nanowire semiconductor devices. In an embodiment, the semiconductor device comprises a nanowire disposed above a substrate. In an embodiment, the nanowire has a first dopant concentration, and the nanowire comprises a pair of tip regions on opposite ends of the nanowire. In an embodiment, the tip regions comprise a second dopant concentration that is greater than the first dopant concentration. In an embodiment, the semiconductor device further comprises a gate structure over the nanowire. In an embodiment, the gate structure is wrapped around the nanowire, and the gate structure defines a channel region of the device. In an embodiment, a pair of source/drain regions are on opposite sides of the gate structure, and both source/drain regions contact the nanowire.

## Description

### TECHNICAL FIELD

Embodiments of the present disclosure relate to semiconductor devices, and more particularly to high voltage nanoribbon and nanowire transistors with tip implants.

### BACKGROUND

As integrated device manufacturers continue to shrink the feature sizes of transistor devices to achieve greater circuit density and higher performance, there is a need to manage transistor drive currents while reducing short-channel effects, parasitic capacitance, and off-state leakage in next-generation devices. Non-planar transistors, such as fin and nanowire-based devices, enable improved control of short channel effects. For example, in nanowire-based transistors the gate stack wraps around the full perimeter of the nanowire, enabling fuller depletion in the channel region, and reducing short-channel effects due to steeper sub-threshold current swing (SS) and smaller drain induced barrier lowering (DIBL).

Different functional blocks within a die may need optimization for different electrical parameters. In some instances high voltage transistors for power applications need to be implemented in conjunction with high speed transistors. High voltage transistors typically suffer from high leakage current. Accordingly, high voltage applications typically rely on fin-based transistors. Fin-based transistors allow thicker gate oxides compared to nanowire devices. In nanowire devices, a thicker oxide results in the space between nanowires being reduced to the point that little or no gate metal can be disposed between the nanowires.

### BRIEF DESCRIPTION OF THE DRAWINGS

Figure 1A is a cross-sectional illustration of a semiconductor device with a first nanowire transistor and a second nanowire transistor, where the nanowires have graded tip junctions, in accordance with an embodiment.
Figure 1B is a cross-sectional illustration of a semiconductor device with an N-type region and a P-type region, where each region includes nanowire transistors with graded tip junctions, in accordance with an embodiment.
Figure 2A is a perspective view illustration of a substrate with alternating semiconductor layers and sacrificial layers, in accordance with an embodiment.
Figure 2B is a perspective view illustration after the layers are patterned to form a plurality of fins comprising nanowires, in accordance with an embodiment.
Figure 2C is a cross-sectional illustration along one of the fins, in accordance with an embodiment.
Figure 2D is a cross-sectional illustration of the fin after sacrificial gate structures are formed over the fin, in accordance with an embodiment.
Figure 2E is a cross-sectional illustration after a portion of the sacrificial layers outside of the sacrificial gate structures are removed, in accordance with an embodiment.
Figure 2F is a cross-sectional illustration after a spacer is formed over the ends of the sacrificial layers and the portions of the nanowires outside of the sacrificial gate structures are removed, in accordance with an embodiment.
Figure 2G is a cross-sectional illustration after first tip regions are formed in first nanowires, in accordance with an embodiment.
Figure 2H is a cross-sectional illustration after second tip regions are formed in second nanowires, in accordance with an embodiment.
Figure 2I is a cross-sectional illustration masking material is removed, in accordance with an embodiment.
Figure 2J is a cross-sectional illustration after source/drain regions are formed over the substrate, in accordance with an embodiment.
Figure 2K is a cross-sectional illustration after the sacrificial gate structures are removed, in accordance with an embodiment.
Figure 2L is a cross-sectional illustration after gate dielectric material is disposed over the nanowires, in accordance with an embodiment.
Figure 2M is a cross-sectional illustration after a gate structure is disposed over the nanowires, in accordance with an embodiment.
Figure 3 illustrates a computing device in accordance with one implementation of an embodiment of the disclosure.
Figure 4 is an interposer implementing one or more embodiments of the disclosure.

### EMBODIMENTS OF THE PRESENT DISCLOSURE

Described herein are semiconductor devices with high voltage nanoribbon and nanowire transistors with tip implants, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

As noted above, high-voltage transistors are susceptible to high leakage currents. Such transistors are typically implemented with fin-based transistors that allow for thicker gate oxides. Fin-based transistors do not provide the same benefits of nanowire devices (e.g., improved short channel effects), and therefore are not an optimal solution. Accordingly, embodiments disclosed herein include nanowire (or nanoribbon) devices with graded tip regions to reduce leakage. Nanowire devices are described in greater detail below. However, it is to be appreciated that substantially similar devices may be formed with nanoribbon channels. A nanowire device may include devices where the channel has a width dimension and a thickness dimension that are substantially similar, whereas a nanoribbon device may include a channel that has a width dimension that is substantially larger or substantially smaller than a thickness dimension. As used herein, "high-voltage" may refer to voltages of approximately 1.0V or higher. Particular embodiments may include high-voltage devices that operate at approximately 1.2V or higher.

In an embodiment, the tip regions are located at opposing ends of each nanowire. The tip regions include a doping concentration that is higher than a doping concentration of the middle portion of the nanowire between the two tip regions. In an embodiment, the tip regions may pass through a spacer on either side of the gate structure. The tip regions may also extend into the channel region in some embodiments. For example, a portion of the tip region may be contacted by a portion of the gate dielectric.

In an embodiment, the high-voltage nanowire transistors may be fabricated in parallel with high-speed nanowire transistors. In some embodiments, the high-voltage nanowire transistor may be fabricated on the same fin as the high-speed nanowire transistor. That is, the nanowires of the high-voltage nanowire transistor may be referred to as being "aligned" with the nanowires of the high-speed nanowire transistor since both transistors are formed from the same fin. The high-voltage nanowire may have a larger channel length L_{g} than the channel length L_{g} of the high-speed nanowire. In some embodiments, both the high-speed device and the high-voltage device include graded tip regions.

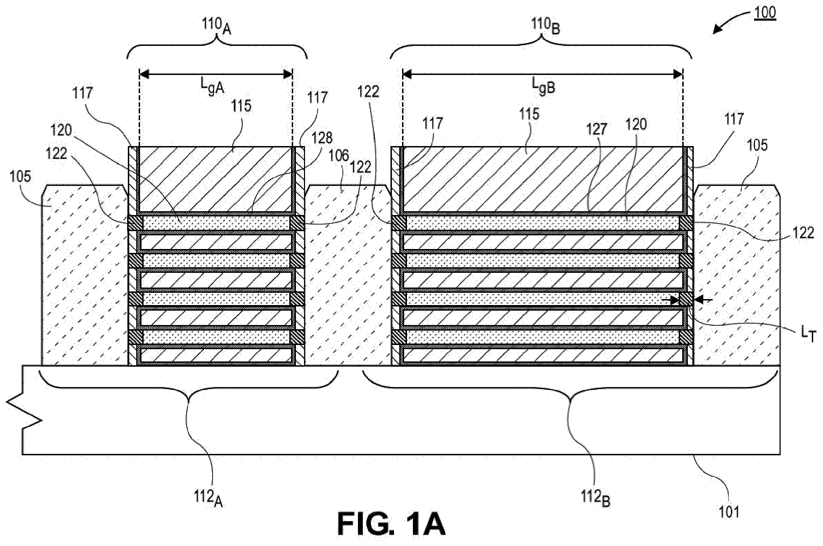

Referring now to Figure 1A, a cross-sectional illustration of an electronic device 100 is shown, in accordance with an embodiment. In an embodiment, the electronic device 100 is formed on a substrate 101. The substrate 101 may include a semiconductor substrate and an isolation layer over the semiconductor substrate. In an embodiment, an underlying semiconductor substrate represents a general workpiece object used to manufacture integrated circuits. The semiconductor substrate often includes a wafer or other piece of silicon or another semiconductor material. Suitable semiconductor substrates include, but are not limited to, single crystal silicon, polycrystalline silicon and silicon on insulator (SOI), as well as similar substrates formed of other semiconductor materials, such as substrates including germanium, carbon, or group III-V materials. The substrate 101 may also comprise an insulating material (e.g., an oxide or the like) that provides isolation between neighboring transistor devices.

In an embodiment, the electronic device 100 may comprise a first transistor 112_{A} and a second transistor 112_{B}. The first transistor 112_{A} and the second transistor 112_{B} may be nanowire transistor devices. That is, the transistors 112_{A} and 112_{B} may each comprise one or more nanowires 120 that extend between source/drain regions 105. The nanowires 120 may pass through spacers 117 that are formed on opposite ends of a gate structures 110_{A} and 110_{B}. The nanowires 120 contact the source/drain regions 105 outside of the spacers 117. In an embodiment, each transistor 112_{A} and 112_{B} comprises a pair of source/drain regions 105 on either side of the spacers 117. In an embodiment, the first transistor 112_{A} and the second transistor 112_{B} may share a common source/drain region 105 (i.e., the middle source/drain region 106 in Figure 1A). In other embodiments, the first transistor 112_{A} may include a pair of source/drain regions 105 that are distinct from a pair of source/drain regions 105 of the second transistor 112_{B}.

The nanowires 120 may comprise any suitable semiconductor materials. For example, the nanowires 120 may comprise silicon or group III-V materials. In an embodiment, the source/drain regions 105 may comprise an epitaxially grown semiconductor material. The source/drain regions 105 and 106 may comprise a silicon alloy. In some implementations, the source/drain regions 105 and 106 comprise a silicon alloy that may be in-situ doped silicon germanium, in-situ doped silicon carbide, or in-situ doped silicon. In alternate implementations, other silicon alloys may be used. For instance, alternate silicon alloy materials that may be used include, but are not limited to, nickel silicide, titanium silicide, cobalt silicide, and possibly may be doped with one or more of boron and/or aluminum. In other embodiments, the source/drain regions 105 and 106 may comprise alternative semiconductor materials (e.g., semiconductors comprising group III-V elements and alloys thereof) or conductive materials.

In an embodiment, each gate structure 110_{A} and 110_{B} may comprise a gate electrode 115 and a gate dielectric 128/127 over the nanowires 120. The gate electrode 115 and the gate dielectric 128/127 wrap around each of the nanowires 120 to provide gate all around (GAA) control of each nanowire 120. The gate structures 110_{A} and 110_{B} define a channel region of each nanowire 120. The channel regions may have a channel length L_{gA} and L_{gB}. The channel length L_{gB} of the second transistor 112_{B} is greater than a channel length L_{gA} of the first transistor 112_{A}. The larger channel length L_{gB} allows for a higher voltage to be used in the second transistor 112_{B} compared to the first transistor 112_{A}. In an embodiment, the channel length L_{gB} may be approximately 50nm or greater or approximately 100nm or greater. In a particular embodiment, the channel length L_{gB} may be approximately 50nm. In an embodiment, the channel length L_{gB} may be up to approximately 250nm.

In an embodiment, the gate dielectric 128/127 may be, for example, any suitable oxide such as silicon dioxide or high-k gate dielectric materials. Examples of high-k gate dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

In an embodiment, the gate electrode 115 may comprise a work function metal. For example, when the metal gate electrode 115 will serve as an N-type workfunction metal, the gate electrode 115 preferably has a workfunction that is between about 3.9 eV and about 4.2 eV. N-type materials that may be used to form the metal gate electrode 115 include, but are not limited to, hafnium, zirconium, titanium, tantalum, aluminum, and metal carbides that include these elements, e.g., titanium carbide, zirconium carbide, tantalum carbide, hafnium carbide and aluminum carbide. Alternatively, when the metal gate electrode 115 will serve as a P-type workfunction metal, the gate electrode 115 preferable has a workfunction that is between about 4.9 eV and about 5.2 eV. P-type materials that may be used to form the metal gate electrode 115 include, but are not limited to, ruthenium, palladium, platinum, cobalt, nickel, and conductive metal oxides, e.g., ruthenium oxide. The gate electrode 115 may also comprise a workfunction metal and a fill metal (e.g., tungsten) over the workfunction metal.

In an embodiment, each of the nanowires 120 may comprise a pair of tip regions 122. The tip regions 122 are on opposite ends of each nanowire 120. In an embodiment, the tip regions 122 comprise a dopant concentration that is greater than a dopant concentration of the remaining portion of the nanowire 120. In an embodiment, the dopants may be P-type dopants or N-type dopants. In an embodiment, the dopant concentration of the tip regions 122 may be 10¹⁷cm⁻³ or greater.

In an embodiment, the tip regions 122 may have a length L_{T} that extends through the spacer 117 and into the channel region. That is, a portion of the spacer 117 may be covered by the gate dielectric 128/127 and be surrounded by the gate electrode 115. For example, the spacer 117 may have a length L_{T} that is approximately 15nm or less, or approximately 10nm or less. It is to be appreciated that transistors that comprise longer channel lengths L_{g} will typically have tip regions 122 with greater lengths L_{T} compared to that of transistors with relatively shorter channel lengths L_{g}. For example, the tip regions 122 in the first transistor 112_{A} may have a shorter length L_{T} than the tip regions 122 in the second transistor 112_{B}. However, in other embodiments, the length L_{T} of the tip regions 122 in the first transistor 112_{A} and the second transistor 112_{B} may be substantially similar to each other.

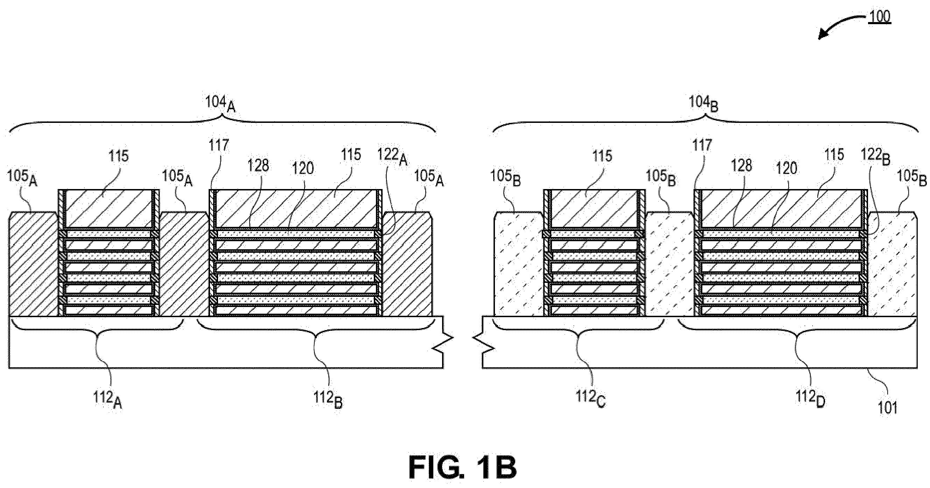

Referring now to Figure 1B, a cross-sectional illustration of an electronic device 100 is shown, in accordance with an additional embodiment. In an embodiment, the electronic device 100 comprises a plurality of nanowire transistors 112_{A-D}. Transistors 112_{A} and 112_{B} are disposed in an N-type region 104_{A}, and transistors 112_{C} and 112_{D} are disposed in a P-type region 104_{B}. Each region 104_{A} and 104_{B} may comprise a short channel transistor (e.g., transistor 112_{A} or transistor 112_{C}) and a long channel transistor (e.g., transistor 112_{B} or transistor 112_{D}).

In some embodiments, the N-type region 104_{A} and the P-type region 104_{B} may be disposed along a single fin. For example, the line breaks in Figure 1B may indicate that both regions 104_{A} and 104_{B} are formed along the same fin. However, it is to be appreciated that in other embodiments, the N-type region 104_{A} and the P-type region 104_{B} may be formed on different fins.

In an embodiment, the N-type region 104_{A} and the P-type region 104_{B} may have structures substantially similar to the transistors described above with respect to Figure 1A. However, it is to be appreciated that material choices may be different between the N-type region 104_{A} and the P-type region 104_{B} in order to accommodate the different conductivity types. For example, the source/drain regions 105_{A} may comprise a different material (e.g., a different material and/or a different dopant) than the source/drain regions 105_{B}. Additionally, the gate dielectrics 128 and the gate electrode 115 materials may be different between the N-type region 104_{A} and the P-type region 104_{B}. Material choices suitable for N-type and P-type transistors are described in greater detail below.

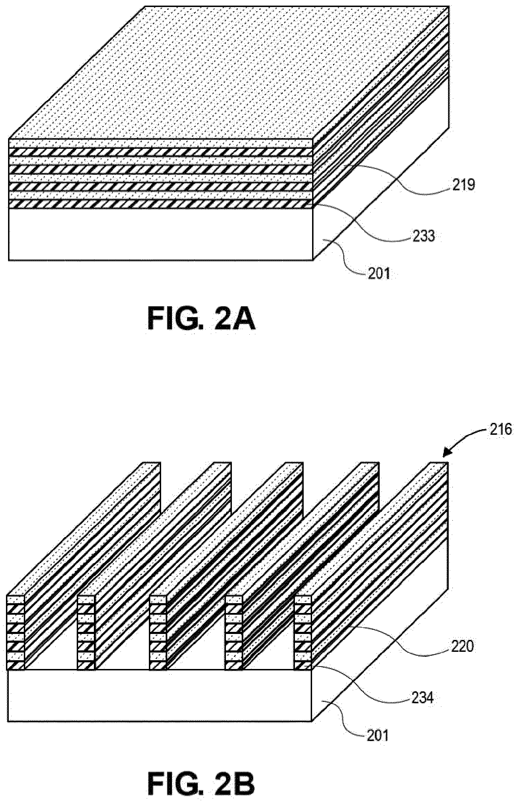

Referring now to Figures 2A-2M, a series of illustrations depicting a process for forming an electronic device with high-voltage nanowire transistors is shown, in accordance with an embodiment.

Referring now to Figure 2A, a perspective view illustration of a substrate 201 is shown, in accordance with an embodiment. In an embodiment, a plurality of alternating layers are stacked over the substrate 201. The substrate 201 may be any substrate such as those described above. The alternating layers may comprise semiconductor layers 219 and sacrificial layers 233. The semiconductor layers 219 are formed chosen for use as the nanowires. The semiconductor layers 219 and sacrificial layers 233 may each be a material such as, but not limited to, silicon, germanium, SiGe, GaAs, InSb, GaP, GaSb, InAlAs, InGaAs, GaSbP, GaAsSb, and InP. In a specific embodiment, the semiconductor layers 219 are silicon and the sacrificial layers 233 are SiGe. In another specific embodiment, the semiconductor layers 219 are germanium, and the sacrificial layers 233 are SiGe.

Referring now to Figure 2B, a perspective view illustration after fins 216 are patterned into the alternating layers is shown, in accordance with an embodiment. In an embodiment, the fins 216 may be formed using any suitable etching process (e.g., dry etching or the like). The patterned sacrificial layers 233 are referred to as sacrificial layers 234, and the patterned semiconductor layers 219 are referred to as nanowires 220. In other embodiments, the fins 216 may have a larger width, and the resulting semiconductor layers 220 may be referred to as nanoribbons.

In the illustrated embodiment, the etching process etches through the alternating layers down to the substrate 201. In other embodiments, the fins 216 may continue into the substrate 201. That is, the fins 216 may comprise a portion of the substrate 201. In an embodiment, an isolation layer (not shown) may fill the channels between the fins. In the case where the fins 216 extend into the substrate 201, the isolation layer may extend up to approximately the bottommost sacrificial layer 234.

In the illustrated embodiment, the fins 216 are depicted as having substantially vertical sidewalls along their entire height. In some embodiments, the sidewalls of the fins 216 may include non-vertical portions. For example, the bottom of the fins proximate to the substrate 201 may have a footing or other similar structural feature typical of high aspect ratio features formed with dry etching processes. Additionally, the profile of all fins may not be uniform. For example, a nested fin may have a different profile than an isolated fin or a fin that is the outermost fin of a grouping of fins.

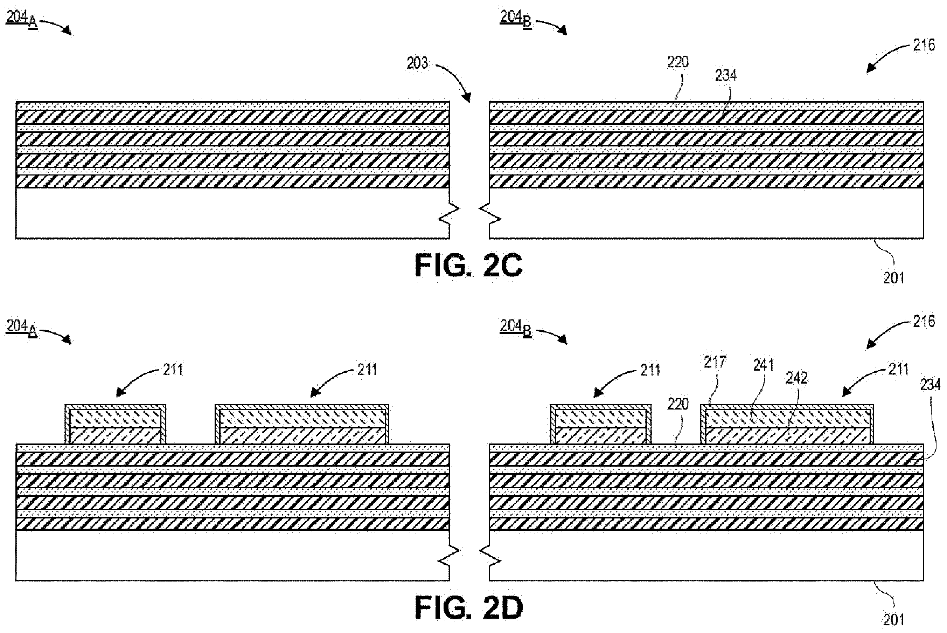

Referring now to Figure 2C, a cross-sectional illustration of a fin 216 along the length of the fin 216 is shown, in accordance with an embodiment. The illustrated embodiment depicts a break 203 along the length of the fin 216. The break 203 may be at some point along the fin 216 that separates an N-type region 204_{A} from a P-type region 204_{B}. Alternatively, the N-type region 204_{A} may be located on a different fin 216 than the P-type region 204_{B}. That is, in some embodiments, the break 203 does not represent a gap within a single fin 216.

Referring now to Figure 2D, a cross-sectional illustration after sacrificial gate structures 211 are disposed over the fin 216 is shown, in accordance with an embodiment. In an embodiment, the sacrificial gate structures 211 may comprise a sacrificial gate 242 and an etchstop layer 241 over the sacrificial gate 242. A spacer 217 may cover the sacrificial gate 242 and the etchstop layer 241. Sidewall portions of the spacer 217 may be disposed on opposite ends of each sacrificial gate structure 211. In the plane depicted in Figure 2D, the sacrificial gate structure 211 and the spacer 217 are disposed over a top surface of the fin 216. However, it is to be appreciated that the sacrificial gate structure 211 and the spacer 217 will wrap down over sidewalls of the fin 216 (i.e., into and out of the plane of Figure 2D).

In an embodiment, the N-type region 204_{A} and the P-type region 204_{B} may each comprise a pair of sacrificial gate structures 211. In an embodiment, the pairs of sacrificial gate structures 211 have a non-uniform length along the fin 216. The non-uniform length allows for different channel lengths to be defined in subsequent processing operations. For example, one sacrificial gate structure 211 may have a relatively short length, and the other sacrificial gate structure 211 may have a relatively long length (e.g., 50nm or greater, 100nm or greater, or 150nm or greater).

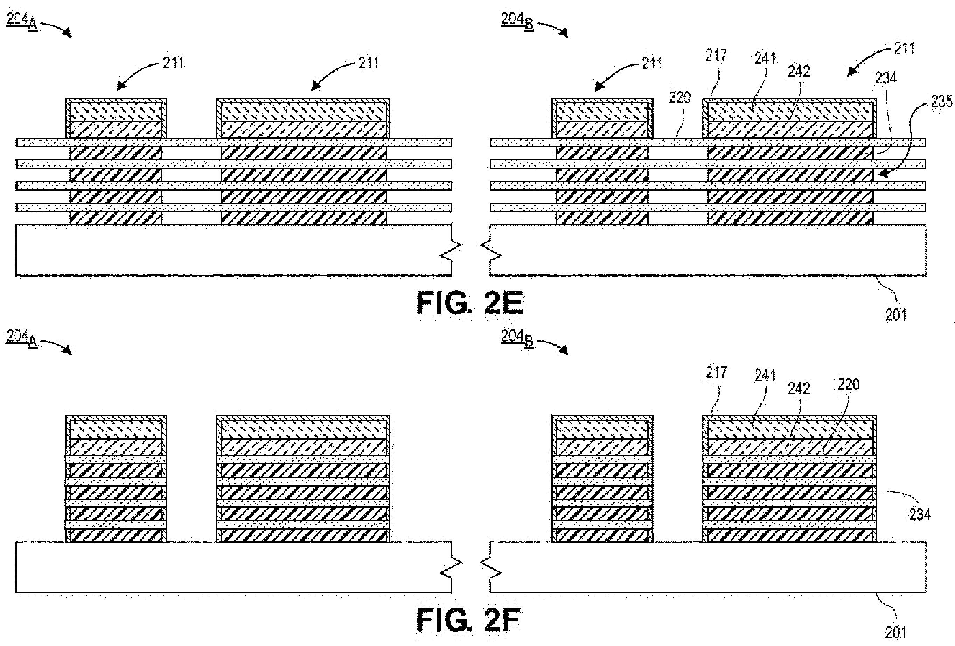

Referring now to Figure 2E, a cross-sectional illustration after portions of the sacrificial layers 234 outside of the sacrificial gate structures 211 are removed is shown, in accordance with an embodiment. Sacrificial layers 234 may be removed using any known etchant that is selective to nanowires 220. In an embodiment, sacrificial layers 234 are removed by a timed wet etch process, timed so as to undercut the external sidewall spacers 217 to form a dimple 235. The selectivity of the etchant is greater than 50:1 for sacrificial material over nanowire material. In an embodiment, the selectivity is greater than 100:1. In an embodiment where nanowires 220 are silicon and sacrificial layers 234 are silicon germanium, sacrificial layers 234 are selectively removed using a wet etchant such as, but not limited to, aqueous carboxylic acid/nitric acid/HF solution and aqueous citric acid/nitric acid/HF solution. In an embodiment where nanowires 220 are germanium and sacrificial layers 234 are silicon germanium, sacrificial layers 234 are selectively removed using a wet etchant such as, but not limited to, ammonium hydroxide (NH₄OH), tetramethylammonium hydroxide (TMAH), ethylenediamine pyrocatechol (EDP), or potassium hydroxide (KOH) solution. In another embodiment, sacrificial layers 234 are removed by a combination of wet and dry etch processes.

Referring now to Figure 2F, a cross-sectional illustration after a spacer layer 214 is disposed in the dimples 235 and the portions of the nanowires 220 outside of the sacrificial gate structure 211 are removed is shown, in accordance with an embodiment. In an embodiment, the spacer layer 214 over the end of the sacrificial layers 234 may be the same material as the spacer layer 217 over the sacrificial gate structure 211. As used herein, the spacer 217 over the sacrificial gate structure 211 and the spacer 214 over the end of the sacrificial layers 234 may both be referred to as a single spacer layer 217. In an embodiment, portions of the nanowires 220 may be removed with an etching process that uses the spacers 217 and the sacrificial gate structures 211 as masks. In some embodiments, the ends of the nanowires 220 may be substantially coplanar with the outer surfaces of the spacers 217.

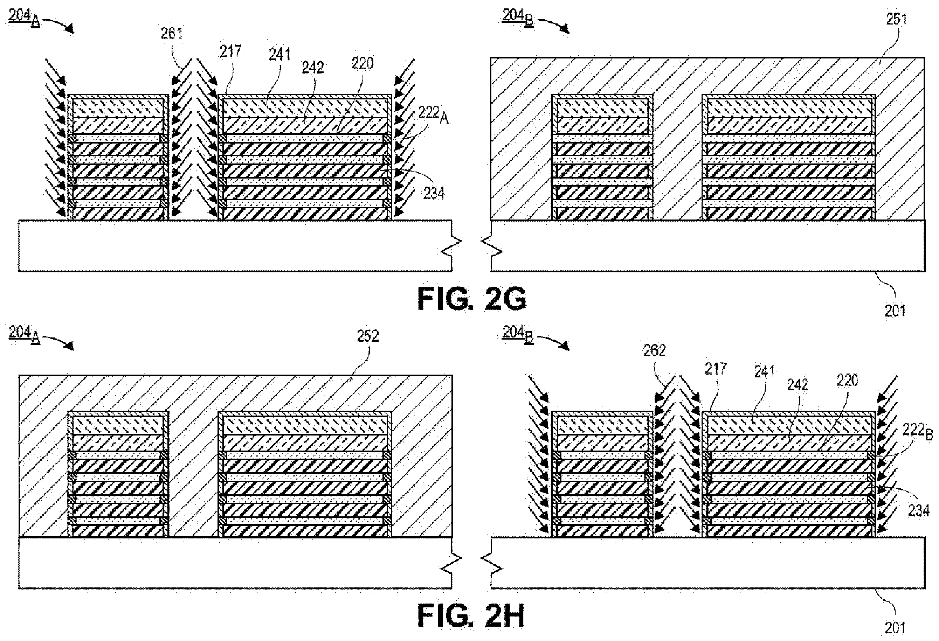

Referring now to Figure 2G, a cross-sectional illustration after first tip regions 222_{A} are formed in the nanowires 220 in the N-type region 204_{A} is shown, in accordance with an embodiment. In an embodiment, N-type dopants may be implanted into the nanowires 220, as shown by the arrows 261. In an embodiment, the dopants are implanted with an angled ion implantation process. In some embodiments, an anneal may be implemented after implantation in order to drive diffusion of the dopants towards the middle of the nanowires 220. In an embodiment, the P-type region 204_{B} is covered by a mask 251 during the implantation operation. For example, a carbon hardmask or the like may be used to protect the P-type region 204_{B} from N-type dopants.

In an embodiment, each nanowire 220 may have a pair of first tip regions 222_{A} disposed on opposite ends of the nanowire 220. The first tip regions 222_{A} may extend a length into the nanowire 220 that extends past the width of the spacers 217. In an embodiment, the length of the first tip regions 222_{A} may be 15nm or less, 10nm or less, or 5nm or less. In an embodiment, the length of the first tip regions 222_{A} may be uniform even between non-uniform nanowire lengths. For example, the length of the first tip regions 222_{A} in the shorter nanowires 220 on the left may be substantially similar to the length of the first tip regions 222_{A} in the longer nanowires 220 on the right.

Referring now to Figure 2H, a cross-sectional illustration after second tip regions 222_{B} are formed in the nanowires 220 in the P-type region 204_{B} is shown, in accordance with an embodiment. The mask 251 may be removed from the P-type region 204_{B} and a mask 252 may be disposed over the N-type region 204_{A}. In an embodiment, P-type dopants may be implanted into the nanowires 220, as shown by the arrows 262. In an embodiment, the dopants are implanted with an angled ion implantation process. In some embodiments, an anneal may be implemented after implantation in order to drive diffusion of the dopants towards the middle of the nanowires 220.

In an embodiment, each nanowire 220 may have a pair of second tip regions 222_{B} disposed on opposite ends of the nanowire 220. The second tip regions 222_{B} may extend a length into the nanowire 220 that extends past the width of the spacers 217. In an embodiment, the length of the second tip regions 222_{B} may be 15nm or less, 10nm or less, or 5nm or less. In an embodiment, the length of the second tip regions 222_{B} may be uniform even between non-uniform nanowire lengths. For example, the length of the second tip regions 222_{B} in the shorter nanowires 220 on the left may be substantially similar to the length of the second tip regions 222_{B} in the longer nanowires 220 on the right. In an embodiment, the length of the first tip regions 222_{A} may be similar to the length of the second tip regions 222_{B}, or the length of the first tip regions 222_{A} may be different than the length of the second tip regions 222_{B}.

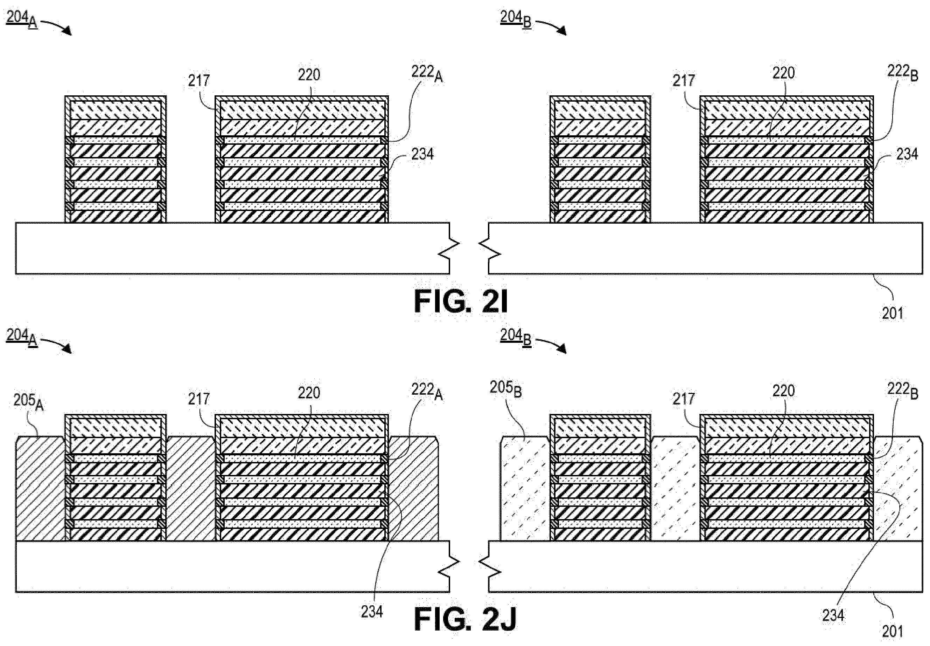

Referring now to Figure 2I, a cross-sectional illustration after the mask layer 252 is removed is shown, in accordance with an embodiment. In an embodiment, the mask layer 252 is removed with any suitable process, such as ashing or the like.

Referring now to Figure 2J, a cross-sectional illustration after source/drain regions 205 are formed is shown, in accordance with an embodiment. In an embodiment, the source/drain regions 205 may be formed with an epitaxial growth process. In an embodiment, N-type epitaxial source/drain regions 205_{A} are grown in the N-type region 204_{A}, and P-type epitaxial source/drain regions 205_{B} are grown in the P-type region 204_{B}. The N-type source/drain regions 205_{A} and the P-type source/drain regions 205_{B} may be formed with materials and processes such as those described in greater detail above. In an embodiment, the source/drain regions 205 directly contact the tip regions 222 of the nanowires 220.

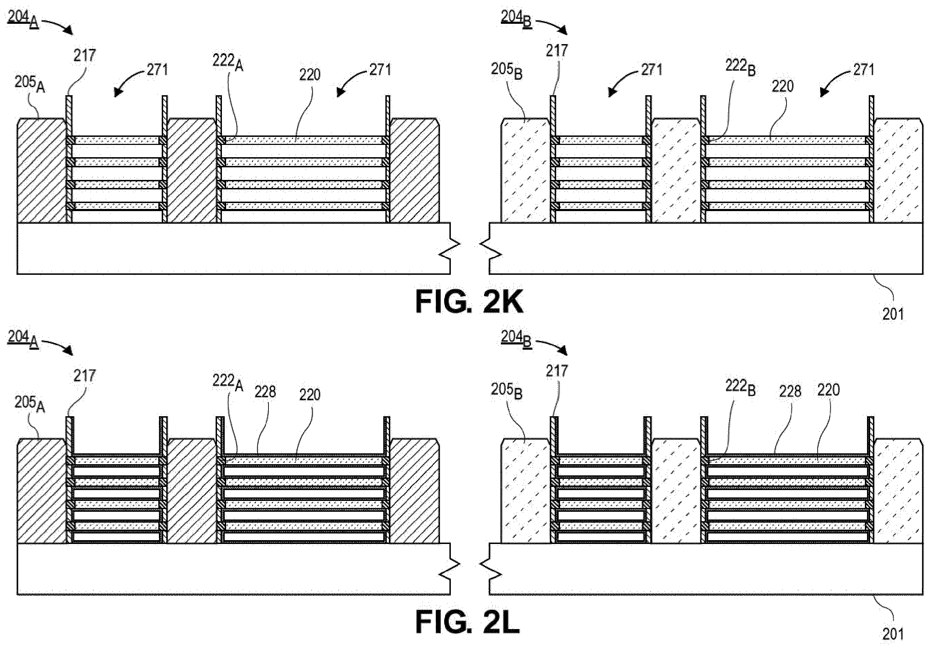

Referring now to Figure 2K, a cross-sectional illustration after the sacrificial gate structures are removed is shown, in accordance with an embodiment. The sacrificial gate structures may be removed with any suitable etching process. After removal of the sacrificial gate structures the remaining portions of the sacrificial layers 234 are removed. In an embodiment, an etching process selective to the sacrificial layer 234 with respect to the nanowires 220 is used to remove the sacrificial layers 234. Suitable etching chemistries and processes are described above. In an embodiment, the removal of the sacrificial gate structures and the sacrificial layers 234 provides openings 271 between the spacers 217. The openings 271 expose the nanowires 220. In an embodiment, portions of the tip regions 222_{A} and 222_{B} are also exposed.

Referring now to Figure 2L, a cross-sectional illustration after a gate dielectric layer 228 is disposed over the nanowires 220 is shown, in accordance with an embodiment. In an embodiment, the gate dielectric 228 may be deposited with a conformal deposition process (e.g., atomic layer deposition (ALD)) in order to completely surround the nanowires 220. The conformal process may also result in portions of the gate dielectric layer 228 being disposed over interior surfaces of the spacers 217. In an embodiment, the gate dielectric 228 may also be disposed directly over portions of the tip regions 222_{A} and 222_{B}. High-k dielectric materials suitable for the gate dielectric 228 are described above.

In the illustrated embodiment, the gate dielectric layer 228 in the N-type region 204_{A} is shown as being the same material as the gate dielectric layer 228 in the P-type region 204_{B}. However, in other embodiments, different materials may be used for the gate dielectric layer 228 in each region 204_{A} and 204_{B}. Additionally, the thickness of the gate dielectric layer 228 is shown as being substantially uniform across all nanowires 220. However, in some embodiments, a thicker gate dielectric layer 228 may be disposed over the nanowires 220 used in the high-voltage applications. For example, the thickness of the gate dielectric layer 228 over the longer nanowires 220 may be greater than the thickness of the gate dielectric layer 228 over the shorter nanowires 220.

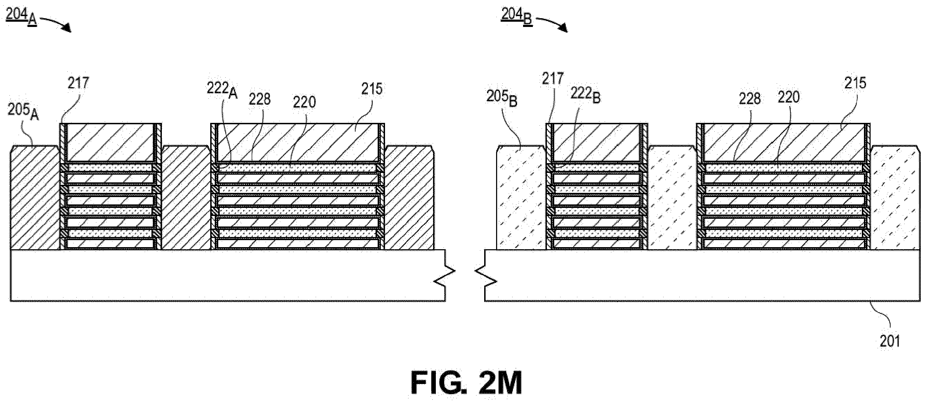

Referring now to Figure 2M, a cross-sectional illustration after a gate electrode 215 is disposed around the nanowires 220 is shown, in accordance with an embodiment. In an embodiment, the gate electrode 215 wraps around each of the nanowires 220 in order to provide GAA control of each nanowire 220. The gate electrode material may be deposited with any suitable deposition process (e.g., chemical vapor deposition (CVD), ALD, etc.). In the illustrated embodiment, a single material is shown as being used to form the gate electrode 215 in the N-type region 204_{A} and the P-type region 204_{B}. However, it is to be appreciated that embodiments may include N-type regions 204_{A} and P-type regions 204_{B} with different materials for the gate electrodes 215 (e.g., with different workfunctions) in order to provide improved performance.

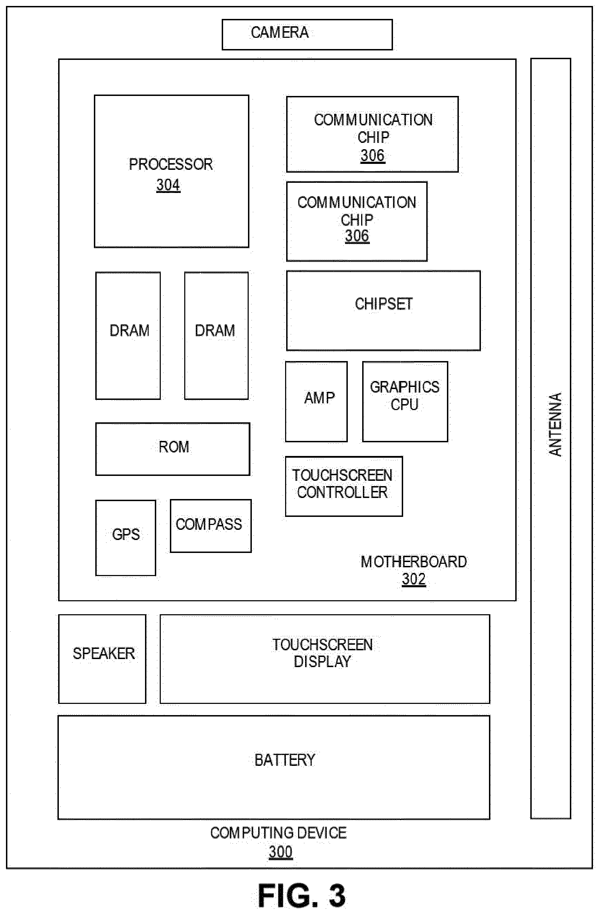

Figure 3 illustrates a computing device 300 in accordance with one implementation of an embodiment of the disclosure. The computing device 300 houses a board 302. The board 302 may include a number of components, including but not limited to a processor 304 and at least one communication chip 306. The processor 304 is physically and electrically coupled to the board 302. In some implementations the at least one communication chip 306 is also physically and electrically coupled to the board 302. In further implementations, the communication chip 306 is part of the processor 304.

Depending on its applications, computing device 300 may include other components that may or may not be physically and electrically coupled to the board 302. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 306 enables wireless communications for the transfer of data to and from the computing device 300. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 306 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 300 may include a plurality of communication chips 306. For instance, a first communication chip 306 may be dedicated to shorter range wireless communications such as Wi-Fi and Bluetooth and a second communication chip 306 may be dedicated to longer range wireless communications such as GPS, EDGE, GPRS, CDMA, WiMAX, LTE, Ev-DO, and others.

The processor 304 of the computing device 300 includes an integrated circuit die packaged within the processor 304. In an embodiment, the integrated circuit die of the processor may comprise nanowire transistor devices with graded tip regions, as described herein. The term "processor" may refer to any device or portion of a device that processes electronic data from registers and/or memory to transform that electronic data into other electronic data that may be stored in registers and/or memory.

The communication chip 306 also includes an integrated circuit die packaged within the communication chip 306. In an embodiment, the integrated circuit die of the communication chip may comprise nanowire transistor devices with graded tip regions, as described herein.

In further implementations, another component housed within the computing device 300 may comprise nanowire transistor devices with graded tip regions, as described herein.

In various implementations, the computing device 300 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 300 may be any other electronic device that processes data.

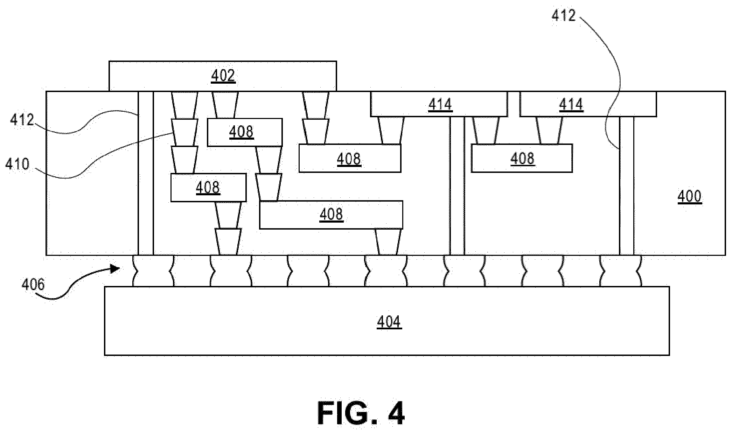

Figure 4 illustrates an interposer 400 that includes one or more embodiments of the disclosure. The interposer 400 is an intervening substrate used to bridge a first substrate 402 to a second substrate 404. The first substrate 402 may be, for instance, an integrated circuit die. The second substrate 404 may be, for instance, a memory module, a computer motherboard, or another integrated circuit die. In an embodiment, one of both of the first substrate 402 and the second substrate 404 may comprise nanowire transistor devices with graded tip regions, a second interference pattern, and a pattern recognition feature, or be fabricated using such an overlay target, in accordance with embodiments described herein. Generally, the purpose of an interposer 400 is to spread a connection to a wider pitch or to reroute a connection to a different connection. For example, an interposer 400 may couple an integrated circuit die to a ball grid array (BGA) 406 that can subsequently be coupled to the second substrate 404. In some embodiments, the first and second substrates 402/404 are attached to opposing sides of the interposer 400. In other embodiments, the first and second substrates 402/404 are attached to the same side of the interposer 400. And in further embodiments, three or more substrates are interconnected by way of the interposer 400.

The interposer 400 may be formed of an epoxy resin, a fiberglass-reinforced epoxy resin, a ceramic material, or a polymer material such as polyimide. In further implementations, the interposer 400 may be formed of alternate rigid or flexible materials that may include the same materials described above for use in a semiconductor substrate, such as silicon, germanium, and other group III-V and group IV materials

The interposer 400 may include metal interconnects 408 and vias 410, including but not limited to through-silicon vias (TSVs) 412. The interposer 400 may further include embedded devices 414, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 400. In accordance with embodiments of the disclosure, apparatuses or processes disclosed herein may be used in the fabrication of interposer 400.

Thus, embodiments of the present disclosure may comprise semiconductor devices that comprise nanowire transistor devices with graded tip regions, and the resulting structures.

The above description of illustrated implementations of the invention, including what is described in the Abstract, is not intended to be exhaustive or to limit the invention to the precise forms disclosed. While specific implementations of, and examples for, the invention are described herein for illustrative purposes, various equivalent modifications are possible within the scope of the invention, as those skilled in the relevant art will recognize.

These modifications may be made to the invention in light of the above detailed description. The terms used in the following claims should not be construed to limit the invention to the specific implementations disclosed in the specification and the claims. Rather, the scope of the invention is to be determined entirely by the following claims, which are to be construed in accordance with established doctrines of claim interpretation.
Example 1: a semiconductor device, comprising: a nanowire disposed above a substrate, the nanowire having a first dopant concentration, and wherein the nanowire comprises a pair of tip regions on opposite ends of the nanowire, wherein the tip regions comprise a second dopant concentration that is greater than the first dopant concentration; a gate structure over the nanowire, the gate structure wrapped around the nanowire, and wherein the gate structure defines a channel region of the device; and a pair of source/drain regions on opposite sides of the gate structure, wherein both source/drain regions contact the nanowire.
Example 2: the semiconductor device of Example 1, further comprising: a pair of spacers on opposite sides of the gate structure, the spacers wrapped around the nanowire.
Example 3: the semiconductor device of Example 2, wherein the tip regions are partially surrounded by the spacers.
Example 4: the semiconductor device of Examples 1-3, wherein the tip regions extend into the channel region.
Example 5: the semiconductor device of Examples 1-4, wherein a length of the tip regions is approximately 10nm or less.
Example 6: the semiconductor device of Examples 1-5, wherein a length of the channel is approximately 50nm or greater.
Example 7: the semiconductor device of Example 6, wherein the length of the channel is approximately 100nm or greater.
Example 8: the semiconductor device of Examples 1-7, wherein the gate structure comprises: a gate oxide over the nanowire within the channel region; and a gate electrode over the gate oxide.
Example 9: the semiconductor device of Example 8, wherein the tip regions are in contact with the gate oxide.
Example 10: a semiconductor device, comprising: a first transistor, comprising: a plurality of first nanowires in a vertical stack, wherein each first nanowire comprises a pair of tip regions on opposite ends of the first nanowire; a first gate structure over the plurality of first nanowires, the first gate structure wrapped around each of the first nanowires, wherein the first gate structure defines a first channel region of the device, the first channel region having a first channel length; and a first pair of source/drain regions on opposite sides of the first gate structure, wherein both source/drain regions contact each of the first nanowires; and a second transistor, comprising: a plurality of second nanowires in a vertical stack, wherein each second nanowire comprises a pair of tip regions on opposite ends of the second nanowire; a second gate structure over the plurality of second nanowires, the second gate structure wrapped around each of the second nanowires, wherein the second gate structure defines a second channel region of the device, the second channel region having a second channel length that is greater than the first channel length; and a second pair of source/drain regions on opposite sides of the second gate structure, wherein both source/drain regions contact each of the second nanowires.
Example 11: the semiconductor device of Example 10, wherein the first transistor is a low voltage transistor, and wherein the second transistor is a high voltage transistor.
Example 12: the semiconductor device of Example 10 and Example 11, wherein the plurality of first nanowires are aligned with the plurality of second nanowires.
Example 13: the semiconductor device of Examples 10-12, wherein the first pair of source/drain regions and the second pair of source/drain regions share a common source/drain region.
Example 14: the semiconductor device of Examples 10-13, further comprising: a first pair of spacers on opposite sides of the first gate structure, the first spacers wrapped around the first nanowires; and a second pair of spacers on opposite sides of the second gate structure, the second spacers wrapped around the second nanowires.
Example 15: the semiconductor device of Example 14, wherein the tip regions are partially surrounded by the first spacers or the second spacers.
Example 16: the semiconductor device of Examples 10-15, wherein the tip regions on the first nanowire have a doping concentration that is higher than a doping concentration of a portion of the first nanowires in the channel region.
Example 17: the semiconductor device of Examples 10-16, wherein the gate structure comprises: a gate oxide over the nanowire within the channel region; and a gate electrode over the gate oxide.
Example 18: the semiconductor device of Example 17, wherein the tip regions are in contact with the gate oxide.
Example 19: a method of forming a semiconductor device, comprising: providing a plurality of alternating sacrificial layers and semiconductor layers over a substrate; patterning the alternating layers to provide a fin, wherein each semiconductor layer is converted formed into a nanowire; forming a first sacrificial gate structure and a second sacrificial gate structure over the fin; forming pairs of spacers on opposite sides of the first sacrificial gate structure and on opposite sides of the second sacrificial gate structure; removing a portion of the fin outside of the first sacrificial gate structure and the second sacrificial gate structure to define first nanowires within the first sacrificial gate structure and second nanowires within the second sacrificial gate structure; forming tip regions on each end of the first nanowires within the first sacrificial gate structure and the second nanowires within the second sacrificial gate structure; forming source/drain regions over the substrate adjacent to each spacer; and replacing the first sacrificial gate structure and the second sacrificial gate structure with a first gate structure and a second gate structure.
Example 20: the method of Example 19, wherein the tip regions are formed with an angled ion implantation process.
Example 21: the method of Example 19 or Example 20, wherein a first channel length of the first gate structure is less than a second channel length of the second gate structure.
Example 22: the method of Examples 19-21, further comprising: forming a third sacrificial gate structure and a fourth sacrificial gate structure over the fin; forming pairs of spacers on opposite sides of the third sacrificial gate structure and on opposite sides of the fourth sacrificial gate structure; removing a portion of the fin outside the third sacrificial gate structure and the fourth sacrificial gate structure to define third nanowires within the third sacrificial gate structure and fourth nanowires within the fourth sacrificial gate structure; protecting the third sacrificial gate and the fourth sacrificial gate during formation of the tip regions on each end of the nanowires under the first sacrificial gate structure and the second sacrificial gate structure; forming tip regions on each end of the third nanowires within the third sacrificial gate structure and fourth nanowires within the fourth sacrificial gate structure, wherein the first sacrificial gate structure and the second sacrificial gate structure are protected during the formation of tip regions under the third sacrificial gate structure and the fourth sacrificial gate structure; and replacing the third sacrificial gate structure and the fourth sacrificial gate structure with a third gate structure and a fourth gate structure.
Example 23: the method of Example 22, wherein the tip regions of the first nanowires and the second nanowires are P-type, and wherein the tip regions of the third nanowires and the fourth nanowires are N-type.
Example 24: an electronic system, comprising: a board; an electronic package attached to the board; and a die electrically coupled to the electronic package, wherein the die comprises: a nanowire disposed above a substrate, the nanowire having a first dopant concentration, and wherein the nanowire comprises a pair of tip regions on opposite ends of the nanowire, wherein the tip regions comprise a second dopant concentration that is greater than the first dopant concentration; a gate structure over the nanowire, the gate structure wrapped around the nanowire, and wherein the gate structure defines a channel region of the device; and a pair of source/drain regions on opposite sides of the gate structure, wherein both source/drain regions contact the nanowire.
Example 25: the electronic system of Example 24, wherein the gate structure comprises: a gate oxide over the nanowire within the channel region; and a gate electrode over the gate oxide, wherein the tip regions are in contact with the gate oxide.

## Claims

1. A semiconductor device, comprising:
a nanowire disposed above a substrate, the nanowire having a first dopant concentration, and wherein the nanowire comprises a pair of tip regions on opposite ends of the nanowire, wherein the tip regions comprise a second dopant concentration that is greater than the first dopant concentration;
a gate structure over the nanowire, the gate structure wrapped around the nanowire, and wherein the gate structure defines a channel region of the device; and
a pair of source/drain regions on opposite sides of the gate structure, wherein both source/drain regions contact the nanowire.

2. The semiconductor device of claim 1, further comprising:
a pair of spacers on opposite sides of the gate structure, the spacers wrapped around the nanowire.

3. The semiconductor device of claim 2, wherein the tip regions are partially surrounded by the spacers.

4. The semiconductor device of claim 1, 2 or 3, wherein the tip regions extend into the channel region.

5. The semiconductor device of claim 1, 2, 3 or 4, wherein a length of the tip regions is approximately 10nm or less.

6. The semiconductor device of claim 1, 2, 3, 4 or 5, wherein a length of the channel is approximately 50nm or greater.

7. The semiconductor device of claim 6, wherein the length of the channel is approximately 100nm or greater.

8. The semiconductor device of claim 1, 2, 3, 4, 5, 6 or 7, wherein the gate structure comprises:
a gate oxide over the nanowire within the channel region; and
a gate electrode over the gate oxide.

9. The semiconductor device of claim 8, wherein the tip regions are in contact with the gate oxide.

10. A method of forming a semiconductor device, comprising:
providing a plurality of alternating sacrificial layers and semiconductor layers over a substrate;
patterning the alternating layers to provide a fin, wherein each semiconductor layer is converted formed into a nanowire;
forming a first sacrificial gate structure and a second sacrificial gate structure over the fin;
forming pairs of spacers on opposite sides of the first sacrificial gate structure and on opposite sides of the second sacrificial gate structure;
removing a portion of the fin outside of the first sacrificial gate structure and the second sacrificial gate structure to define first nanowires within the first sacrificial gate structure and second nanowires within the second sacrificial gate structure;
forming tip regions on each end of the first nanowires within the first sacrificial gate structure and the second nanowires within the second sacrificial gate structure;
forming source/drain regions over the substrate adjacent to each spacer; and
replacing the first sacrificial gate structure and the second sacrificial gate structure with a first gate structure and a second gate structure.

11. The method of claim 10, wherein the tip regions are formed with an angled ion implantation process.

12. The method of claim 10 or 11, wherein a first channel length of the first gate structure is less than a second channel length of the second gate structure.

13. The method of claim 10, 11 or 12, further comprising:
forming a third sacrificial gate structure and a fourth sacrificial gate structure over the fin;
forming pairs of spacers on opposite sides of the third sacrificial gate structure and on opposite sides of the fourth sacrificial gate structure;
removing a portion of the fin outside the third sacrificial gate structure and the fourth sacrificial gate structure to define third nanowires within the third sacrificial gate structure and fourth nanowires within the fourth sacrificial gate structure;
protecting the third sacrificial gate and the fourth sacrificial gate during formation of the tip regions on each end of the nanowires under the first sacrificial gate structure and the second sacrificial gate structure;
forming tip regions on each end of the third nanowires within the third sacrificial gate structure and fourth nanowires within the fourth sacrificial gate structure, wherein the first sacrificial gate structure and the second sacrificial gate structure are protected during the formation of tip regions under the third sacrificial gate structure and the fourth sacrificial gate structure; and
replacing the third sacrificial gate structure and the fourth sacrificial gate structure with a third gate structure and a fourth gate structure.

14. The method of claim 13, wherein the tip regions of the first nanowires and the second nanowires are P-type, and wherein the tip regions of the third nanowires and the fourth nanowires are N-type.
